# EUROPEAN PATENT APPLICATION

(11) **EP 4 742 874 A2**
(43) Date of publication of application: **13.05.2026**
(21) Application number: 26164274.8
(22) Date of filing: 20.08.2024
(51) Int. Cl.: H10K 59/95

(54) **DISPLAY DEVICE**

(30) Priority: 31.08.2023 KR 20230115321; 26.06.2024 KR 20240083837
(62) Divisional of application: 24195266.2
(71) Applicant: LG Display Co., Ltd., Seoul, 07336 (KR)
(72) Inventor: CHOI, JoungMi, 10845 Paju-si (KR); CHUNG, EuiHyun, 10845 Paju-si (KR)
(74) Representative: Morrall, Jonathan Ian McLachlan

(57) **Abstract**

A display device includes a display panel which includes a plurality of pixels and includes a substrate divided into a first area disposed at the center and a second area which encloses the first area; and a gate driver including a plurality of stages configured to supply a gate signal to the pixels through gate lines. Each of the plurality of stages included in the gate driver is disposed in a gate area which at least partially overlaps the first area and the second area, the plurality of pixels includes a plurality of first pixels disposed on the first area and a plurality of second pixels disposed on the second area, and the first pixels may be disposed in the first area at a first density and the second pixels may be disposed in the second area at a second pixel density which is lower than the first pixel density.

## Description

### CROSS-REFERENCE TO RELATED APPLICATIONS

This application claims the priority of Korean Patent Application No. 10-2023-0115321 filed on August 31, 2023 and No. 10-2024-0083837 filed on June 26, 2024, in the Korean Intellectual Property Office, the disclosure of which are incorporated herein by reference.

### BACKGROUND

### Field

The present disclosure relates to a display device.

### Description of the Related Art

As it enters an information era, a display field which visually expresses electrical information signals has been rapidly developed, and in response to this, various display devices having excellent performances such as thin-thickness, light weight, and low power consumption have been developed. Examples of such a display device include a liquid crystal display device (LCD), an organic light emitting display device (OLED), and the like.

An applicable range of the display device is diversified to personal digital assistants as well as monitors of computers and televisions, and a display device with a large display area and a reduced volume and weight is being studied.

Recently, a display device which is manufactured by forming a display unit, a wiring line, and the like on a flexible substrate such as plastic which is a flexible material so as to be stretchable in a specific direction and changeable in various forms is getting attention as a next generation display device.

### SUMMARY

An object to be achieved by the present disclosure is to provide a display device which minimizes a bezel area.

Another object to be achieved by the present disclosure is to provide a display device in which an outer peripheral area can be modified to have a curved shape.

Objects of the present disclosure are not limited to the above-mentioned objects, and other objects, which are not mentioned above, can be clearly understood by those skilled in the art from the following descriptions.

In order to achieve the objects as described above, according to an aspect of the present disclosure, a display device includes a display panel which includes a plurality of pixels and includes a substrate divided into a first area disposed at the center of the display device and a second area which encloses (surrounds) the first area; a data driver configured to supply a data signal to the pixels through data lines; and a gate driver including a plurality of stages configured to supply a gate signal to the pixels through gate lines. Each of the plurality of stages included in the gate driver is disposed in a gate area which at least partially overlaps the first area and the second area, the plurality of pixels includes a plurality of first pixels disposed on the first area and a plurality of second pixels disposed on the second area, and the first pixels may be disposed in the first area at a first pixel density and the second pixels may be disposed in the second area at a second pixel density which is lower than the first pixel density.

Other detailed matters of the exemplary embodiments are included in the detailed description and the drawings.

In the display device according to the exemplary embodiments of the present disclosure, a gate area in which various components configuring a gate driver are disposed is disposed so as to overlap at least a part of an active area (a first area and a second area) in which various components configuring a pixel are disposed. That is, the gate driver is disposed and formed on a gate area in a gate in array (GIA) manner so that a bezel area of the display device may be minimized.

Further, a display device according to exemplary embodiments of the present disclosure includes a first area which is a center area, and a second area which is an outer peripheral area enclosing (surrounding) the first area. Second pixels disposed in the second area may be disposed with a lower pixel density than that of the first pixels disposed in the first area. Therefore, in the second area which is an outer peripheral area, the display device can be modified so that the second area which is the outer peripheral area may be configured to have a curved shape.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a plan view illustrating a display device according to exemplary embodiments of the present disclosure;
FIG. 2A is a cross-sectional view illustrating an example taken along the line I-I' of FIG. 1;
FIG. 2B is a cross-sectional view illustrating an example taken along the line II-II' of FIG. 1;
FIG. 3 is a view for explaining an example of a placement relationship of a first pixel disposed on a first area of a display device of FIG. 1;
FIG. 4 is a view for explaining an example of a placement relationship of a second pixel disposed on a second area of a display device of FIG. 1;
FIG. 5 is a plan view illustrating a display device according to exemplary embodiments of the present disclosure;
FIG. 6 is a view illustrating an example of a gate driver disposed on a gate area of a display device of FIG. 5;
FIG. 7 is a cross-sectional view schematically illustrating an example of a display panel included in a display device of FIG. 5;
FIG. 8 is an enlarged view illustrating an example of enlarging a part of a first sub area, a second sub area, a fifth sub area, a sixth sub area, a seventh sub area, and an eighth sub area of FIG. 5;
FIG. 9A is an enlarged view illustrating an example of enlarging a part of a third sub area and a fourth sub area of FIG. 5;
FIG. 9B is an enlarged view illustrating another example of enlarging a part of a third sub area and a fourth sub area of FIG. 5; and
FIG. 10 is a cross-sectional view illustrating an example taken along the line III-III' of FIG. 5.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

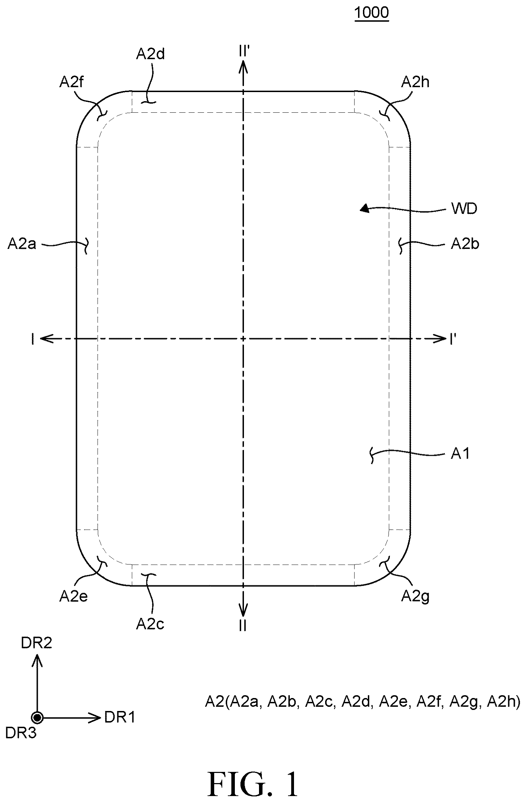

FIG. 1 is a plan view illustrating a display device according to exemplary embodiments of the present disclosure.

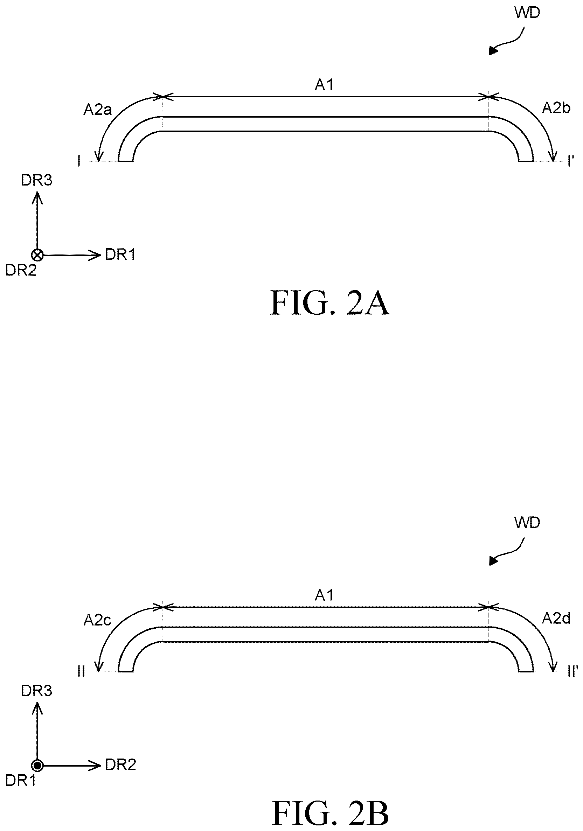

FIG. 2A is a cross-sectional view illustrating an example taken along the line I-I' of FIG. 1.

FIG. 2B is a cross-sectional view illustrating an example taken along the line II-II' of FIG. 1.

FIG. 1 may be a view illustrating a front surface of a display device 1000 according to exemplary embodiments of the present disclosure.

Even though in FIG. 1, it is illustrated that the display device 1000 is implemented in the form of a smart phone, it is not limited thereto and the display device 1000 may be implemented as various electronic devices (for example, a smart watch, a tablet PC, or the like).

Even though in FIGS. 1, 2A, and 2B, for the convenience of description, among components included in the display device 1000, only a window WD is illustrated.

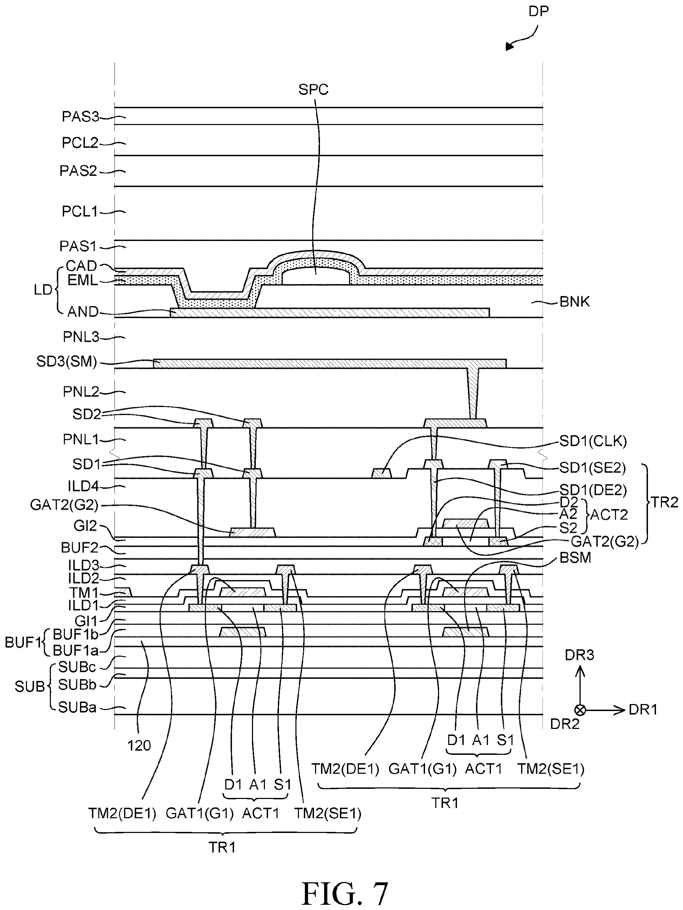

Referring to FIG. 1, the display device 1000 according to exemplary embodiments of the present disclosure may include a display panel DP (see FIG. 7) and a window WD (see FIGS. 2A and 2B) which covers the display panel DP (see FIG. 7).

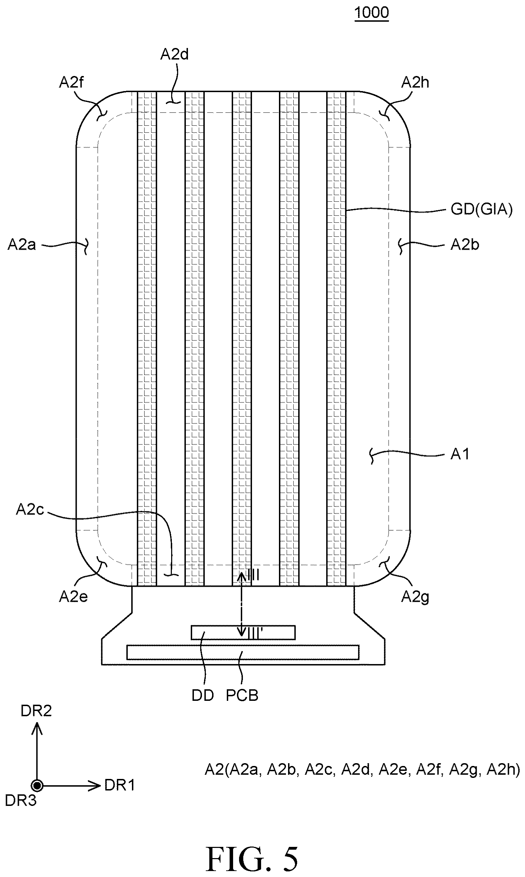

The display device 1000 may display images through a display surface. Here, the display surface may be defined as an area in which images are displayed. The display device 1000 may include a display panel DP (see FIG. 5) and the display panel DP (see FIG. 5) may include a plurality of pixels for displaying images.

The display surface in which images are displayed may be parallel to a surface defined by a first directional axis (for example, an axis extending in a first direction DR1) and a second directional axis (for example, an axis extending in a second direction DR2). Typically, these are known as the x and y directions respectively. A normal direction of the display surface, that is, a thickness direction of the display device 1000 may be defined as a third direction DR3. Typically, this is known as the z direction.

Front surfaces (or top surfaces) and rear surfaces (or bottom surfaces) of components or units of the display device 1000 to be described below may be distinguished by the third direction DR3. However, the first to third directions DR1 (for example an x direction), DR2 (for example a y direction), and DR3 (for example a z direction) illustrated in the specification are just illustrative and the first to third directions DR1, DR2, and DR3 are relative concepts to be converted into other directions. Hereinafter, for the convenience of description, the same reference numerals refer to the first to third directions DR1, DR2, and DR3, respectively.

When represented as "overlapping", it means that two components overlap in the thickness direction (that is, the third direction DR3) of the display device 1000, unless otherwise defined.

The display surface of the display device 1000 may be used not only as an area in which images are displayed, but also as an area in which a touch input of a user is recognized (for example, a sensing area or a touch area). In this case, the display device 1000 may further include a touch sensor. Depending on an exemplary embodiment, an area in which a touch input of the user is recognized may correspond to the above-described display surface and overlap at least a part of the display surface.

In FIG. 1, even though it is illustrated that the display device 1000 has a rounded corner at which one long side and one short side intersect, this is just illustrative and the shape of the display device 1000 is not limited thereto. For example, the display device 1000 may have an angled shape, etc. at the corner in which one long side and one short side intersect.

In one exemplary embodiment, the display device 1000 may include a display surface with a flat center area and a display surface with a curved outer peripheral area (for example, an edge area). For example, a front surface of the display device 1000 may be set as a display surface.

To be more specific, the display device 1000 may include a first area A1 and a second area A2 excluding the first area A1. For example, the second area A2 may be defined as an area which encloses (or can be considered to surround) the first area A1. The first area A1 may occupy the most area of the display surface.

In one exemplary embodiment, the second area A2 may include a left area, a right area, a lower area, an upper area, and a corner area of the first area A1. For example, the second area A2 may include a first sub area A2a (for example, a left area) adjacent to one side along the first direction DR1 of the first area A1, a second sub area A2b (for example, a right area) adjacent to the other side along the first direction DR1 of the first area A1, a third sub area A2c (for example, a lower area) adjacent to one side along the second direction DR2 of the first area A1, a fourth sub area A2d (for example, an upper area) adjacent to one side along the second direction DR2 of the first area A1, a fifth sub area A2e (for example, a first corner area) between the first sub area A2a and the third sub area A2c, a sixth sub area A2f (for example, a second corner area) between the first sub area A2a and the fourth sub area A2d, a seventh sub area A2g (for example, a third corner area) between the second sub area A2b and the third sub area A2c, and an eighth sub area A2h (for example, the fourth corner area) between the second sub area A2b and the fourth sub area A2d.

According to the exemplary embodiment, the first area A1 is a flat shape which is an area corresponding to a center area of the display device 1000 and the second area A2 (for example, first to eighth sub areas A2a to A2h) may be a curved shape which is an area corresponding to an outer peripheral area (edge area) of the display device 1000.

For example, further referring to FIGS. 2A and 2B, as illustrated in FIG. 2A (taken along the line I-I' of FIG. 1), the first sub area A2a and the second sub area A2b may have a curved shape bent along a direction (for example, a first strain direction) which is substantially parallel to the first direction DR1. Further, as illustrated in FIG. 2B (taken along the line II-II' of FIG. 1), the third sub area A2c and the fourth sub area A2d may have a curved shape bent along a direction (for example, a second strain direction) which is substantially parallel to the second direction DR2. Even though it is not illustrated in FIGS. 2A and 2B, each of the fifth to eighth sub areas (A2e to A2h) may have a curved shape bent along the first direction DR1 and the second direction DR2 (for example, the first strain direction and the second strain direction). The first direction DR1 may be substantially parallel to the one short side of the display device 1000, and the second direction may be substantially parallel to the one long side of the display device 1000, but the first direction DR1 and the second direction DR2 are not limited thereto.

In one exemplary embodiment, the display device 1000, for example, a part corresponding to each of the first to eighth sub areas A2a to A2h of the display panel DP (see FIG. 5) included in the display device 1000 may have a bendable or stretchable property. For example, the display device 1000, for example, a part corresponding to each of the first to eighth sub areas A2a to A2h of the display panel DP (see FIG. 5) included in the display device 1000 may have not only flexibility, but also stretchability. Accordingly, a shape of the display device 1000 corresponding to the first to eight sub areas A2a to A2h may be freely modified so that it may be designed to have a curved shape in a corresponding area.

This will be described below in more detail with reference to FIGS. 1 to 5.

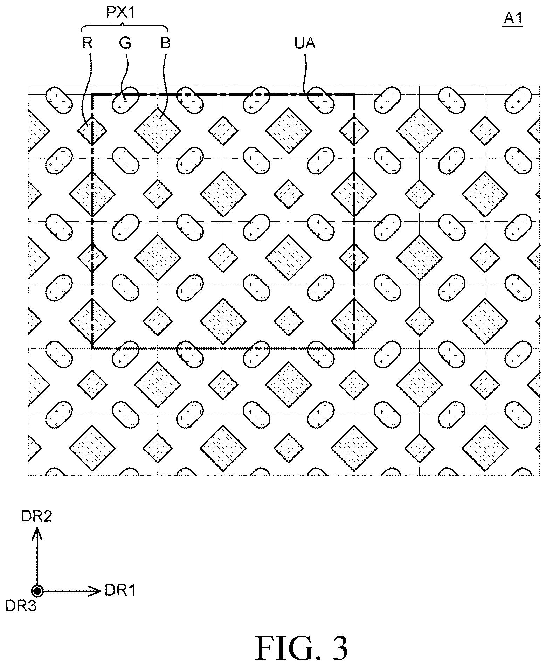

FIG. 3 is a view for explaining an example of a placement relationship of a first pixel disposed on a first area of a display device of FIG. 1.

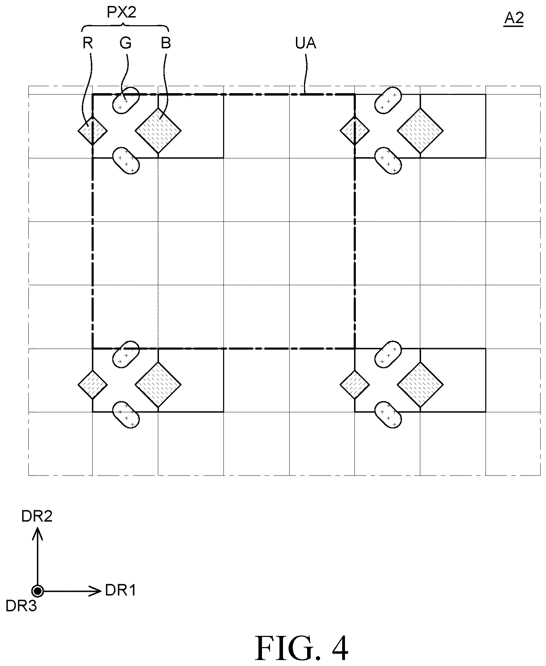

FIG. 4 is a view for explaining an example of a placement relationship of a second pixel disposed on a second area of a display device of FIG. 1.

Referring to FIGS. 1, 2A, 2B, 3, and 4, the display device 1000 may include a first area A1 and a second area A2. As described with reference to FIGS. 1, 2A, and 2B, the first area A1 is an area corresponding to the center area of the display device 1000 and may have a flat shape and the second area A2 is an area corresponding to the outer peripheral area (edge area) of the display device 1000 and may have a curved shape.

The display device 1000 may include a plurality of first pixels PX1 disposed in the first area A1 and a plurality of second pixels PX2 disposed in the second area A2. Each of the first pixels PX1 and each of the second pixels PX2 include at least one sub pixel, among a red sub pixel R, a green sub pixel G, and a blue sub pixel B. In some cases, at least some of the first pixels PX1 and the second pixels PX2 may further include a white sub pixel (not illustrated).

According to the exemplary embodiment, a luminous efficiency of the light emitting diode may be determined depending on the colors of the sub pixels R, G, and B. In consideration of this, sizes of the sub pixels R, G, and B may be determined depending on the colors.

For example, among the sub pixels R, G, and B, the blue sub pixel B may have the largest size and the green sub pixel G may have the smallest size, but this is just illustrative, and the exemplary embodiment of the present disclosure is not limited thereto.

In one exemplary embodiment, the display device 1000 may have a different pixel density for every area.

For example, the display device 1000 may include a plurality of first pixels PX1 disposed on the first area A1 and a plurality of second pixels PX2 disposed on the second area A2. Here, the first pixel PX1 may be disposed on the first area A1 with a first pixel density and the second pixel PX2 may be disposed on the second area A2 with a second pixel density which is smaller than the first pixel density.

Here, the pixel density may be defined as a total area of a part in which actual pixels are disposed, with respect to the entire size of the corresponding area or defined as a total area of pixels included in a predetermined unit area. Here, the area in which each pixel is disposed may be an area of an emission surface of a light emitting diode included in each pixel. For example, when the pixel includes an organic light emitting diode, an area of the pixel may be an area of an anode electrode exposed between pixel definition films, or an area of an emission layer.

To be more specific, as illustrated in FIGS. 3 and 4, in the first area A1 and the second area A2, a unit area UA with the same size may be defined.

Here, with reference to the unit area UA, the first pixel PX1 disposed on the first area A1 may be disposed with a first pixel density which is relatively large. For example, in the first area A1, the first pixels PX1 may be disposed at a high PPI. Therefore, an image with a high resolution may be displayed in the first area A1 which occupies the most area of the display surface and corresponds to the center area.

Here, with reference to the unit area UA, the second pixel PX2 disposed on the second area A2 may be disposed with a second pixel density which is relatively small. Here, the second pixel density is smaller than the first pixel density and for example, the first pixel density may be eight times the second pixel density, but this is just illustrative, and the exemplary embodiment of the present disclosure is not limited thereto. For example, the second area A2 may be disposed at a PPI lower than a PPI of the first pixels PX2 of the first area A1.

Here, as described above, the second area A2 is an outer peripheral area (edge area) and may have a curved shape bent along the strain direction. For example, a substrate of the display device 1000 is configured by a flexible substrate. A plurality of rigid plate patterns is disposed on the substrate to be spaced apart from each other. The second pixel PX2 of the unit area UA of the second area A2 is disposed on the rigid plate pattern. In an area in which the second pixel PX2 is not disposed, connection lines with a wavy shape are disposed so that the display device 1000 may be stretched in the second area A2. Therefore, the display device 1000 may have a curved shape which is bent along the strain direction on the second area A2.

FIG. 5 is a plan view illustrating a display device according to exemplary embodiments of the present disclosure.

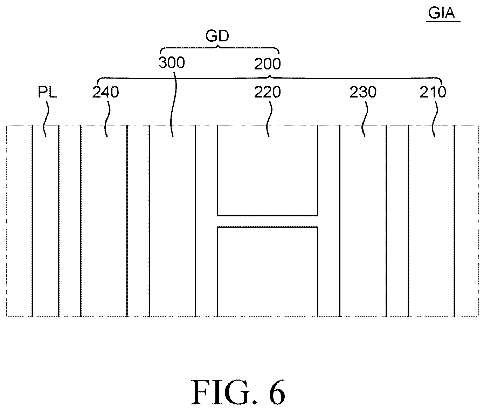

FIG. 6 is a view illustrating an example of a gate driver disposed on a gate area of a display device of FIG. 5.

In order to avoid redundant descriptions, contents which do not overlap the description with reference to FIGS. 1 to 4 will be mainly described. A part which is not specifically described follows the above-described exemplary embodiment and the same reference numeral denotes the same component, and the like reference numeral denotes the like component.

Referring to FIG. 5, a display device 1000 according to the exemplary embodiments of the present disclosure may include a display panel DP, a plurality of pixels PX, a gate driver GD, and a data driver DD. In one exemplary embodiment, the display device 1000 may further include a printed circuit board PCB.

As described above, the display device 1000 may include the first area A1 and the second area A2. For example, the display panel DP of the display device 1000 may include the substrate as the first area A1 and the second area A2. Here, the first area A1 and the second area A2 may be defined as active areas.

Each pixel PX (for example, a first pixel PX1 of the first area A1 and/or a second pixel PX2 of the second area A2) may include a display element and various driving elements for driving the display element. For example, various driving elements may include at least one thin film transistor (TFT) and a capacitor. Further, the pixels PX may be connected to various wiring lines, respectively. For example, each of the pixels PX may be connected to various wiring lines, such as a gate line (for example, a scan signal line or an emission signal line), a data line, and a power voltage line.

Further, the display panel DP may include a gate area GIA. The gate area GIA may overlap at least a part of the first area A1 and at least a part of the second area A2. For example, a plurality of gate areas GIA which extends along the second direction DR2 and is spaced apart from each other along the first direction DR1 may be disposed so as to overlap a part of the first area A1 and the second area A2 (for example, the third and fourth sub areas A2c and A2d).

In FIG. 5, even though it is illustrated that the display panel DP includes five gate areas GIA, this is just illustrative, but the exemplary embodiment of the present disclosure is not limited thereto.

The gate driver GD may be disposed on the gate area GIA. For example, the gate driver GD may be formed on the gate area GIA overlapping at least a part of the first area A1 and the second area A2 in a gate in array manner. For example, the gate driver GD may be disposed on the same layer as a layer on which the pixel PX is disposed on the display panel DP or may be disposed on a different layer depending on the exemplary embodiment. Accordingly, a bezel of the display device 1000 may be minimized.

Further referring to FIG. 6, a scan driver 200 configured to supply a scan signal to the pixels PX and an emission driver 300 configured to supply an emission control signal to the pixels PX may be disposed on the gate area GIA. The scan driver 200 may include a first scan driver 210 (SC1) configured to supply a first scan signal to the pixels PX, a second scan driver 220 (SC2) configured to supply a second scan signal to the pixels PX, a third scan driver 230 (SC3) configured to supply a third scan signal to the pixels PX, and a fourth scan driver 240 (SC4) configured to supply a fourth scan signal to the pixels PX.

For example, components (for example, transistors, capacitors, various connection signal lines, and the like) included in the first scan driver 210, components (for example, transistors, capacitors, various connection signal lines, and the like) included in the second scan driver 220, components (for example, transistors, capacitors, various connection signal lines, and the like) included in the third scan driver 230, components (for example, transistors, capacitors, various connection signal lines, and the like) included in the fourth scan driver 240, and components (for example, transistors, capacitors, various connection signal lines, and the like) included in the emission driver 300 may be disposed on the gate area GIA.

Further, a power line PL configured to supply a low potential voltage VSS to the pixels PX may be disposed together on the gate area GIA. As described above, the power line PL configured to supply a low potential voltage VSS is disposed to overlap the first area A1 and the second area A2 which are the active areas to minimize the bezel of the display device 1000.

Referring to FIG. 5 again, the printed circuit board PCB may transmit signals and voltages for driving the display element from a controller to the display element. Therefore, the printed circuit board PCB may also be referred to as a driving substrate. A controller, such as an IC chip or a circuit unit, may be mounted on the printed circuit board PCB. Further, on the printed circuit board PCB, a memory, a processor, or the like may also be mounted.

The data driver DD may supply the data signal to the pixels PX disposed in the first area A1 and/or the second area A2. For example, the data driver DD may supply the data signal to the pixels PX through data lines.

In one exemplary embodiment, the data driver DD is configured as an integrated circuit chip (IC chip) to be referred to as a data integrated circuit. The data driver DD may be mounted in a chip on film (COF) manner, a chip on board (COB) manner, a chip on glass (COG) manner, a tape carrier package (TCP) manner, or the like.

Hereinafter, a specific cross-sectional structure of a display panel DP will be described with reference to FIG. 7.

FIG. 7 is a cross-sectional view schematically illustrating an example of a display panel included in a display device of FIG. 5.

Referring to FIGS. 5 to 7, at least one transistor TR1 and TR2 and a light emitting diode LD may be disposed on the substrate SUB.

A first transistor TR1, among transistors disposed on the substrate SUB, may be a polysilicon semiconductor transistor. For example, the first transistor TR1 may be a p-type MOSFET transistor (PMOS transistor) including a polysilicon semiconductor layer formed by a low temperature poly-silicon (LTPS) process as an active layer (channel).

Further, a second transistor TR2, among transistors disposed on the substrate SUB, may be an oxide semiconductor transistor. For example, the second transistor TR2 may be an n-type MOSFET transistor (NMOS transistor) including an oxide semiconductor layer as an active layer (channel).

The substrate SUB is a base member of the display panel DP and may be substantially a transparent and transmissive substrate. The substrate SUB may be a flexible substrate formed of a plastic material. Here, the flexible property may be interpreted as the same meaning as bendable, unbreakable, rollable, and foldable properties.

For example, the substrate SUB may include plastic and, in this case, the substrate SUB may be referred to as a plastic film or a plastic substrate. For example, the substrate SUB may include at least one selected from a group consisting of a polyester-based polymer, a silicon-based polymer, an acrylic polymer, a polyolefin-based polymer, and a polymer thereof. For example, the substrate SUB may include polyimide (PI).

When the substrate SUB includes polyimide (PI), moisture passes through the substrate SUB formed of polyimide (PI) and permeates the thin film transistor included in the pixel PX so that the reliability of the pixel PX is lowered and thus a performance of the display device 1000 may be degraded.

Accordingly, in one exemplary embodiment, the substrate SUB may include double polyimide (PI). Further, the substrate SUB further includes an inorganic film formed between two polyimides (PI) to block the moisture components from permeating the lower polyimide (PI), so that the reliability of the product performance may be further improved. Further, an inorganic film is formed between two polyimides (PI) to block charges charged in the lower polyimide (PI), thereby improving the reliability of the product.

For example, as illustrated in FIG. 7, the substrate SUB may include a first sub substrate SUBa including polyimide (PI), a second substrate SUBb which is disposed on the first sub substrate SUBa and includes an inorganic insulating material, and a third sub substrate SUBc which is disposed on the second sub substrate SUBb and includes polyimide PI.

The inorganic insulating material included in the second sub substrate SUBb may be formed by a single layer of silicon nitride SiNₓ or silicon oxide SiOₓ or a multi-layer thereof. However, this is just illustrative so that the exemplary embodiment of the present disclosure is not limited thereto. For example, the inorganic insulating material included in the second sub substrate SUBb may include a silicon oxide SiOₓ material. For example, the inorganic insulating material included in the second sub substrate SUBb may include silicon dioxide (silica, SiO₂). As another example, the inorganic insulating material included in the second sub substrate SUBb may be formed by a double layer of silicon dioxide SiO₂ and silicon nitride SiNₓ.

Even though it is not separately illustrated in FIG. 7, a back plate and a metal plate may be further disposed below the substrate SUB.

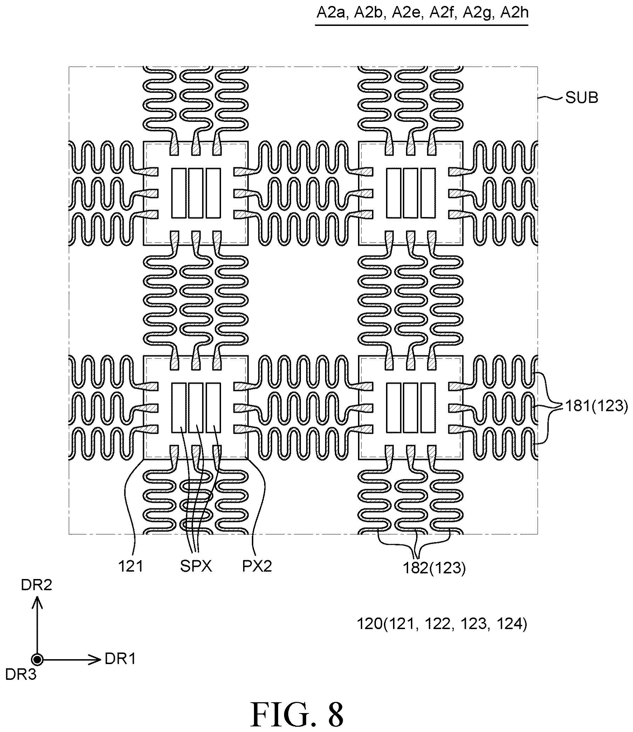

A pattern layer 120 may be disposed on the substrate SUB. The pattern layer 120 supports the pixel PX, the gate driver GD, and connection lines and may include a plurality of plate patterns and a plurality of line patterns disposed on the second area A2. The pattern layer 120 will be described in more detail with reference to FIGS. 8 to 10.

A shielding metal layer including at least one shielding metal pattern BSM may be disposed on the substrate SUB (or the pattern layer 120).

The shielding metal pattern BSM included in the shielding metal layer may be formed by a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

According to an exemplary embodiment, the shielding metal pattern BSM may be defined as a component included in the first transistor TR1. For example, the shielding metal pattern BSM may configure a lower gate electrode of the first transistor TR1.

The first buffer layer BUF1 may be disposed on the substrate SUB (or the pattern layer 120). For example, the first buffer layer BUF1 may be disposed on the substrate SUB (or the pattern layer 120) so as to cover the shielding metal pattern BSM.

In one exemplary embodiment, the first buffer layer BUF1 may include a multi-buffer layer BUF1a disposed on the substrate SUB (or the pattern layer 120) and an active buffer layer BUF1b disposed on the multi-buffer layer BUF1a.

The first transistor TR1 may be disposed on the first buffer layer BUF1. The first transistor TR1 may include a first semiconductor pattern ACT1, a first gate electrode G1, a source electrode SE1, and a drain electrode DE1. According to the exemplary embodiment, as described above, the first transistor TR1 may further include the shielding metal pattern BSM disposed between the first buffer layer BUF1 and the substrate SUB.

A first semiconductor layer including at least one first semiconductor pattern ACT1 may be disposed on the first buffer layer BUF1.

For example, the first semiconductor pattern ACT1 included in the first transistor TR1 of the first semiconductor layer may be disposed on the first buffer layer BUF1. The first semiconductor pattern ACT1 may include a first region S1 (or a source electrode or a source region), a second region D1 (or a drain electrode or a drain region), and a channel region A1 therebetween. Further, as described above, the first semiconductor pattern ACT1 may include a polysilicon semiconductor layer formed by a low temperature poly-silicon (LTPS) process.

A first gate insulating layer GI1 may be disposed on the first semiconductor layer, for example, the first semiconductor pattern ACT1. For example, the first gate insulating layer GI1 is disposed so as to cover the first semiconductor layer, for example, the first semiconductor pattern ACT1 to insulate the first semiconductor pattern ACT1 of the first transistor TR1 from the first gate electrode G1.

For example, the first gate insulating layer GI1 may be configured by a single layer of silicon nitride SiNₓ or silicon oxide SiOₓ or a multi-layer thereof but is not limited thereto.

A first conductive layer GAT1 may be disposed on the first gate insulating layer GI1. The first conductive layer GAT1 may configure at least a part of an emission control line configured to supply an emission control signal to the pixels PX, a scan line configured to supply a scan signal, and a power line configured to supply various power voltages. Here, when the first conductive layer GAT1 configures at least a part of the power line configured to supply a power voltage, the first conductive layer GAT1 may include a material having a high conductivity, such as a metal or conductive oxide. For example, the first conductive layer GAT1 may be formed by a single layer or a multi-layer including aluminum (Al), copper (Cu), titanium (Ti), or the like. In some exemplary embodiment, the first conductive layer GAT1 may be provided as a triple layer of titanium, aluminum, and titanium (Ti/Al/Ti) which are sequentially disposed. However, the first conductive layer GTA1 is not limited thereto and may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

A first gate electrode G1 of the first transistor TR1 which configures at least a part of the emission control line or the scan line of the first conductive layer GAT1 may be disposed on the first gate insulating layer GI1.

The first gate electrode G1 of the first transistor TR1 may be disposed to overlap at least a part of the first semiconductor pattern ACT1.

A first insulating layer ILD1 may be disposed on the first conductive layer GAT1, for example, the first gate electrode G1 of the first transistor TR1. For example, the first insulating layer ILD1 may be disposed to cover the first conductive layer GAT1, for example, the first gate electrode G1 of the first transistor TR1.

The first insulating layer ILD1 may be configured by a single layer of silicon nitride SiNₓ or silicon oxide SiOx or a multi-layer thereof but is not limited thereto.

A second conductive layer TM1 may be disposed on the first insulating layer ILD1. The second conductive layer TM1 includes molybdenum (Mo), copper (Cu), titanium (Ti), and the like, and may be formed by a single layer or a multi-layer.

A second insulating layer ILD2 may be disposed on the second conductive layer TM1. For example, the second insulating layer ILD2 may be disposed so as to cover the second conductive layer TM1.

The first insulating layer ILD1 may be configured by a single layer of silicon nitride SiNₓ or silicon oxide SiOx or a multi-layer thereof but is not limited thereto.

A third conductive layer TM2 may be disposed on the second insulating layer ILD2. The third conductive layer TM2 includes molybdenum (Mo), copper (Cu), titanium (Ti), and the like, and may be formed by a single layer or a multi-layer.

For example, a first source electrode SE1 and a first drain electrode DE1 of the first transistor TR1 of the third conductive layer TM2 may be disposed on the second insulating layer ILD2. The first source electrode SE1 of the first transistor TR1 of the third conductive layer TM2 may be in contact with a first region S1 of the first semiconductor pattern ACT1 through a contact hole which passes through the second insulating layer ILD2, the first insulating layer ILD1, and the first gate insulating layer GI1. The first drain electrode DE1 of the first transistor TR1 of the third conductive layer TM2 may be in contact with a second region D1 of the first semiconductor pattern ACT1 through the contact hole which passes through the second insulating layer ILD2, the first insulating layer ILD1, and the first gate insulating layer GI1.

A third insulating layer ILD3 may be disposed on the third conductive layer TM2, for example, the first source electrode SE1 and the first drain electrode DE1 of the first transistor TR1. For example, the third insulating layer ILD3 may be disposed so as to cover the third conductive layer TM2.

The third insulating layer ILD3 may be configured by a single layer of silicon nitride SiNₓ or silicon oxide SiOₓ or a multi-layer thereof but is not limited thereto.

The second buffer layer BUF2 may be disposed on the third insulating layer ILD3.

The second buffer layer BUF2 may be configured by a single layer of silicon nitride SiNₓ or silicon oxide SiOₓ or a multi-layer thereof but is not limited thereto.

A second semiconductor layer including at least one second semiconductor pattern ACT2 may be disposed on the second buffer layer BUF2.

For example, the second semiconductor pattern ACT2 included in the second transistor TR2 of the second semiconductor layer may be disposed on the second buffer layer BUF2. The second semiconductor pattern ACT2 may include a first region S2 (or a source electrode or a source region), a second region D2 (or a drain electrode or a drain region), and a channel region A2 therebetween. Further, as described above, the second semiconductor pattern ACT2 may include an oxide semiconductor layer.

A second gate insulating layer GI2 may be disposed on the second semiconductor layer, for example, the second semiconductor pattern ACT2. The second gate insulating layer GI2 may be configured by a single layer of silicon nitride SiNₓ or silicon oxide SiOₓ or a multi-layer thereof but is not limited thereto.

A fourth conductive layer GAT2 may be disposed on the second gate insulating layer GI2. The fourth conductive layer GAT2 includes molybdenum (Mo), copper (Cu), titanium (Ti), and the like, and may be formed by a single layer or a multi-layer.

For example, the second gate electrode G2 of the second transistor TR2 which configures at least a part of the scan line of the fourth conductive layer GAT2 may be disposed on the second gate insulating layer GI2.

The second gate electrode G2 of the second transistor TR2 may be disposed to overlap at least a part of the second semiconductor pattern ACT2.

A fourth insulating layer ILD4 may be disposed on the fourth conductive layer GAT2, for example, the second gate electrode G2 of the second transistor TR2. For example, the fourth insulating layer ILD4 may be disposed to cover the fourth conductive layer GAT2, for example, the second gate electrode G2 of the second transistor TR2.

A fifth conductive layer SD1 may be disposed on the fourth insulating layer ILD4. The fifth conductive layer SD1 may configure at least a part of the power line configured to supply a power voltage. Here, since the fifth conductive layer SD1 configures at least a part of the power line configured to supply a power voltage, the fifth conductive layer SD1 may include a material having a high conductivity, such as a metal or conductive oxide. For example, the fifth conductive layer SD1 may be formed by a single layer or a multi-layer including aluminum (Al), copper (Cu), titanium (Ti), or the like. In some exemplary embodiment, the fifth conductive layer SD1 may be provided as a triple layer of titanium, aluminum, and titanium (Ti/Al/Ti) which are sequentially disposed. However, the fifth conductive layer SD1 is not limited thereto and may be formed of a single layer, or a multi-layer formed of any one of molybdenum (Mo), copper (Cu), titanium (Ti), aluminum (Al), chrome (Cr), gold (Au), nickel (Ni), and neodymium (Nd) or an alloy thereof.

Further, at least a part of the fifth conductive layer SD1 may serve as a connection electrode. For example, at least a part of the fifth conductive layer SD1 may be connected to the source electrode SE1 and/or the drain electrode DE1 of the first transistor TR1 of the third conductive layer TM2 through a contact hole which passes through the fourth insulating layer ILD4, the second gate insulating layer GI2, the second buffer layer BUF2, and the third insulating layer ILD3. Alternatively, at least a part of the fifth conductive layer SD1 may be in contact with a part of the fourth conductive layer GAT2 through a contact hole which passes through the fourth insulating layer ILD4.

Further, at least a part of the fifth conductive layer SD1 may configure the second source electrode SE2 and the second drain electrode DE2 of the second transistor TR2. For example, the second source electrode SE2 of the second transistor TR2 of the fifth conductive layer SD1 may be in contact with a first region S2 of the second semiconductor pattern ACT2 through a contact hole which passes through the fourth insulating layer ILD4 and the second gate insulating layer GI2. The second drain electrode DE2 of the second transistor TR2 of the fifth conductive layer SD1 may be in contact with a second region D2 of the second semiconductor pattern ACT2 through the contact hole which passes through the fourth insulating layer ILD4 and the second gate insulating layer GI2.

In one exemplary embodiment, at least a part of the fifth conductive layer SD1 may configure a clock line CLK configured to supply a clock signal to the gate driver GD disposed on the gate area GIA of the display panel DP which has been described with reference to FIGS. 5 and 6. For example, at least a part of the fifth conductive layer SD1 may configure a clock line CLK which transmits a clock signal which is an input signal of each stage included in the gate driver GD (for example, the scan driver 200 and/or the emission driver 300) disposed on the gate area GIA. For example, the clock line CLK of the fifth conductive layer SD1 which transmits a clock signal may be electrically connected to each stage (for example, at least a part of a transistor which configures each stage) of the gate driver GD by means of a line jumping structure.

A first planarization layer PNL1 may be disposed on the fifth conductive layer SD1. The first planarization layer PNL1 may be an organic layer which planarizes an upper portion and protects components disposed therebelow. For example, the first planarization layer PNL1 may include an organic material, such as acryl resin, epoxy resin, phenolic resin, polyamide resin, or polyimide resin.

A sixth conductive layer SD2 may be disposed on the first planarization layer PNL1.

The sixth conductive layer SD2 may configure at least a part of a data line configured to supply a data signal to the pixels PX or a power line configured to supply a high potential power voltage VDD. Here, since the sixth conductive layer SD2 configures at least a part of the power line configured to supply a power voltage, the sixth conductive layer SD2 may include a material having a high conductivity, such as a metal or conductive oxide. For example, the sixth conductive layer SD2 may be formed by a single layer or a multi-layer including aluminum (Al), copper (Cu), titanium (Ti), or the like. In some exemplary embodiment, the sixth conductive layer SD2 may be provided as a triple layer of titanium, aluminum, and titanium (Ti/Al/Ti) which are sequentially disposed. However, the sixth conductive layer SD2 is not limited thereto and may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

Further, at least a part of the sixth conductive layer SD2 may serve as a connection electrode. For example, at least a part of the sixth conductive layer SD2 may be connected to at least a part of the fifth conductive layer SD1 through a contact hole which passes through the first planarization layer PNL1.

A second planarization layer PNL2 may be disposed on the sixth conductive layer SD2. The second planarization layer PNL2 may be an organic layer which planarizes an upper portion and protects components disposed therebelow. For example, the second planarization layer PNL2 may include an organic material, such as acryl resin, epoxy resin, phenolic resin, polyamide resin, or polyimide resin.

A seventh conductive layer SD3 may be disposed on the second planarization layer PNL2. The seventh conductive layer SD3 may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

In one exemplary embodiment, at least a part of the seventh conductive layer SD3 may serve as a shielding pattern SM. For example, as described above, at least a part of the fifth conductive layer SD1 configures at least a part of a clock line CLK which transmits a clock signal to the gate driver GD. Therefore, there may be signal interference between the clock line CLK of the fifth conductive layer SD1 and the anode electrode AND of the light emitting diode LD disposed thereabove. In this case, a voltage of the anode electrode AND of the light emitting diode LD is unstable so that a display quality of the desired pixel PX may deteriorate. Therefore, in the case of the display device 1000 according to the exemplary embodiments of the present disclosure, the seventh conductive layer SD3 disposed above the second planarization layer PNL2 serves as a shielding pattern SM which shields a signal between at least a part (for example, a clock line CLK) of the fifth conductive layer SD1 and the anode electrode AND of the light emitting diode LD. Therefore, the display quality may be improved.

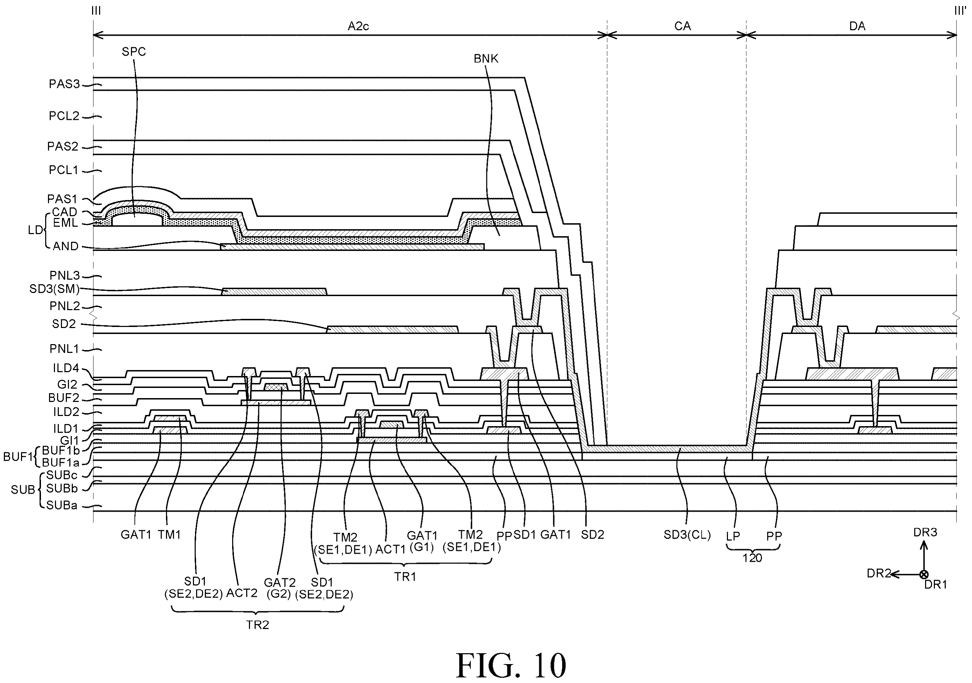

According to the exemplary embodiment, for the shielding function, the shielding pattern SM of the seventh conductive layer SD3 may have a width larger than a width of the anode AND of the light emitting diode LD. Conductive layer SD3 and conductive layer SD2 may be positioned on layers that are in-between the layers where TR1 and/or TR2 and the light emitting diode LD are positioned as shown in FIG. 10.

Further, at least a part of the seventh conductive layer SD3 may be connected to at least a part of the sixth conductive layer SD2 through a contact hole which passes through the second planarization layer PNL2.

A third planarization layer PNL3 may be disposed on the seventh conductive layer SD3. The third planarization layer PNL3 may be an organic layer which planarizes an upper portion and protects components disposed therebelow. For example, the third planarization layer PNL3 may include an organic material, such as acryl resin, epoxy resin, phenolic resin, polyamide resin, or polyimide resin.

The light emitting diode LD may be disposed on the third planarization layer PNL3. The light emitting diode LD may include an anode electrode AND (or a first electrode), a cathode electrode CAD (or a second electrode), and an emission layer EML formed therebetween.

The anode electrode AND may be disposed on the third planarization layer PNL3.

When the display device 1000 is a top emission type in which light emitted from the light emitting diode LD is emitted above the substrate SUB in which the light emitting diode LD is disposed, the anode electrode AND may further include a transparent conductive layer and a reflective layer on the transparent conductor layer. The transparent conductive layer may be formed of transparent conductive oxide such as ITO or IZO and the reflective layer may include, for example, silver (Ag), aluminum (Al), gold (Au), molybdenum (Mo), tungsten (W), chrome (Cr), an alloy thereof, or the like.

A bank layer BNK is disposed so as to cover at least a part of the anode electrode AND and may open the remaining part of the anode electrode AND. For example, the bank layer BNK may be disposed to open a part corresponding to an emission area of the pixel PX. Therefore, the part of the anode electrode AND may be exposed by the open part of the bank layer BNK.

The bank layer BNK may include an inorganic insulating material, such as silicon nitride SiNₓ or silicon oxide SiOₓ, or an organic insulating material, such as benzocyclobutene resin, acrylic resin or imide resin, but is not limited thereto.

The emission layer EML may be disposed on the front surface of the pixel PX on top surfaces of the bank layer BNK and the anode electrode AND. A part of the emission layer EML may be in contact with the exposed part of the anode electrode AND by the open part of the bank layer BNK.

According to the exemplary embodiment, the emission layer EML may include a plurality of organic films.

The cathode electrode CAD may be disposed on the emission layer EML. For example, the cathode electrode CAD may be disposed on the front surface of the pixel PX.

The light emitting diode LD may be formed by the anode electrode AND, the emission layer EML, and the cathode electrode CAD.

A spacer SPC may be provided so as not to cause a screen mask and the substrate to be in contact with each other during a process of depositing the emission layer EML. The spacer SPC is disposed on the bank layer BNK and the emission layer EML and the cathode electrode CAD may be applied so as to pass over the spacer SPC disposed in the active area AA.

According to the exemplary embodiment, the emission layer EML and/or the cathode electrode CAD may not pass over the spacer SPC. The spacer SPC is disposed only in a part of the bank BNK in the active area AA so that even though the cathode electrode CAD does not pass over the spacer SPC, the cathode electrode CAD may be connected while covering the overall active area AA.

An encapsulation layer may be disposed above the light emitting diode LD. For example, the encapsulation layer may include a first inorganic encapsulation layer PAS1, a first organic encapsulation layer PCL1 on the first inorganic encapsulation layer PAS1, a second inorganic encapsulation layer PAS2 on the first organic encapsulation layer PCL1, a second organic encapsulation layer PCL2 on the second inorganic encapsulation layer PAS2, and a third inorganic encapsulation layer PAS3 on the second organic encapsulation layer PCL2. The first inorganic encapsulation layer PAS1, the second inorganic encapsulation layer PAS2, and the third inorganic encapsulation layer PAS3 may serve to block the permeation of moisture or oxygen. For example, the first inorganic encapsulation layer PAS1, the second inorganic encapsulation layer PAS2, and the third inorganic encapsulation layer PAS3 may be formed of an inorganic material such as silicon nitride, aluminum nitride, zirconium nitride, titanium nitride, hafnium nitride, tantalum nitride, silicon oxide, aluminum oxide, or titanium nitride. The first inorganic encapsulation layer PAS1, the second inorganic encapsulation layer PAS2, and the third inorganic encapsulation layer PAS3 may be formed by a chemical vapor deposition process or an atomic layer deposition process.

The first organic encapsulation layer PCL1 may be disposed between the first inorganic encapsulation layer PAS1 and the second inorganic encapsulation layer PAS2 and the second organic encapsulation layer PCL2 may be disposed between the second inorganic encapsulation layer PAS2 and the third inorganic encapsulation layer PAS3. The first organic encapsulation layer PCL1 and the second organic encapsulation layer PCL2 may be formed with a thickness larger than that of the first inorganic encapsulation layer PAS1, the second inorganic encapsulation layer PAS2, and the third inorganic encapsulation layer PAS3 to suck and/or block particles. The particles may be generated during the manufacturing process. The first organic encapsulation layer PCL1 and the second organic encapsulation layer PCL2 may be formed of an organic material such as silicon oxy carbon SiOCz acryl or epoxy resin. The first organic encapsulation layer PCL1 and the second organic encapsulation layer PCL2 may be formed by a coating process, such as an inkjet coating process or a slit coating process.

FIG. 8 is an enlarged view illustrating an example of enlarging a part of a first sub area, a second sub area, a fifth sub area, a sixth sub area, a seventh sub area, and an eighth sub area of FIG. 5.

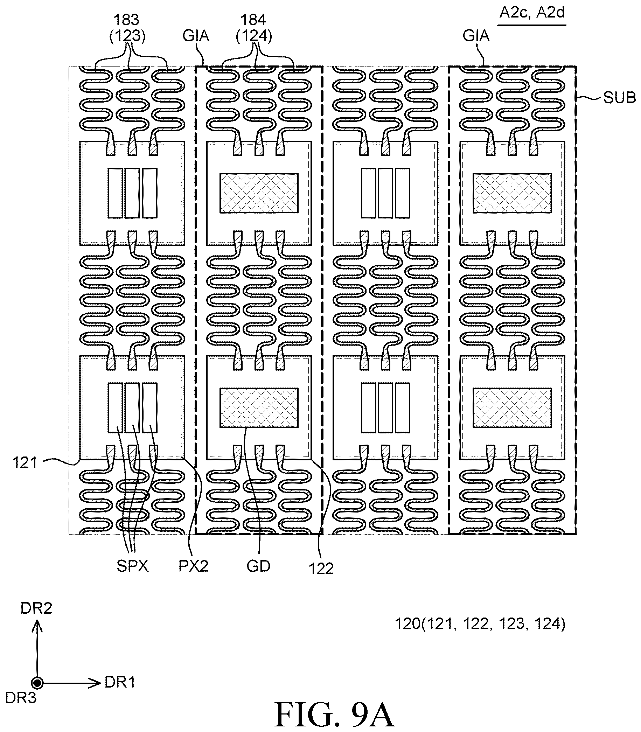

FIG. 9A is an enlarged view illustrating an example of enlarging a part of a third sub area and a fourth sub area of FIG. 5.

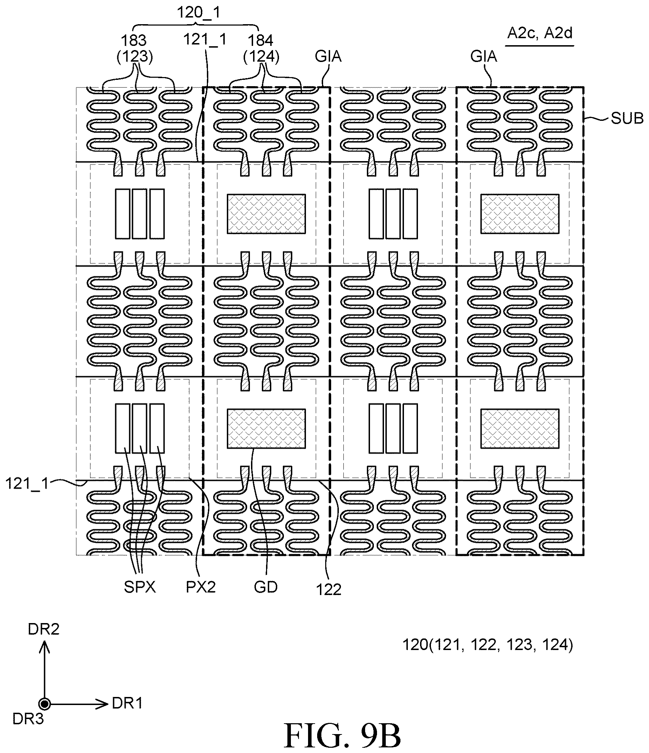

FIG. 9B is an enlarged view illustrating another example of enlarging a part of a third sub area and a fourth sub area of FIG. 5.

FIG. 8 is an enlarged view illustrating an example of a plan view of enlarging a part of any one sub area, among a first sub area A2a, a second sub area A2b, a fifth sub area A2e, a sixth sub area A2f, a seventh sub area A2g, and an eighth sub area A2h. FIG. 9A is an enlarged view illustrating an example of a plan view of enlarging a part of any one sub area of the third sub area A2c and the fourth sub area A2d. FIG. 9B is an enlarged view illustrating another example of a plan view of enlarging a part of any one sub area of the third sub area A2c and the fourth sub area A2d. This reflects the GIA of figure 5 in areas A2c and A2d.

Referring to FIGS. 1, 3, 4, 5 to 9A, the display device 1000 according to the exemplary embodiments of the present disclosure may include a substrate SUB, a pattern layer 120, a plurality of pixels PX, a gate driver GD, and a data driver DD.

As described above, the substrate SUB is a base member of the display panel DP and is a substrate for supporting and protecting various components of the display device 1000.

The substrate SUB is a flexible substrate so as to be reversibly expanded and contracted. Therefore, the substrate SUB may be referred to as a stretchable substrate, an elastic substrate, a stretching substrate, or a flexible substrate. Further, a modulus of elasticity of the substrate SUB may be several MPa to several hundreds of MPa. Further, a ductile breaking rate of the substrate SUB may be 100%. Here, the ductile breaking rate refers to a stretching rate at a timing when an object to be stretched is broken or cracked.

The pattern layer 120 may be disposed on the substrate SUB. In one exemplary embodiment, the pattern layer 120 may support a pixel PX, a gate driver GD, and connection lines 181, 182, 183, and 184 disposed on the second area A2.

In one exemplary embodiment, the pattern layer 120 may include a plurality of first plate patterns 121, a plurality of second plate patterns 122, a plurality of line patterns 123, and a plurality of second line patterns 124 disposed in the second area A2.

The first plate patterns 121 may be disposed on the second area A2 of the substrate SUB. For example, the first plate patterns 121 may be disposed above the first to eighth sub areas A2a to A2h of the substrate SUB, respectively. Further, as illustrated in FIGS. 5, 8, and 9A, a plurality of second pixels PX2 including a plurality of sub pixels SPX (for example, sub pixels R, G, and B described with reference to FIG. 4) may be disposed on the first plate pattern 121.

The first plate patterns 121 may be spaced apart from each other to be disposed on the second area A2 of the substrate SUB. For example, as illustrated in FIGS. 8 and 9A, the first plate patterns 121 may be disposed on the second area A2 of the substrate SUB in a matrix, but this is just illustrative, but the exemplary embodiment of the present disclosure is not limited thereto.

The second plate patterns 122 may be disposed on the second area A2 of the substrate SUB. For example, the second plate patterns 122 may be disposed above the third and fourth sub areas A2c and A2d of the substrate SUB, respectively. Further, as illustrated in FIGS. 5 and 9A, the gate driver GD may be disposed on the second plate patterns 122. For example, various transistors, capacitors, and signal lines which configure the gate driver GD may be disposed on the second plate patterns 122.

The second plate patterns 122 may be spaced apart from each other to be disposed on a part (for example, third and fourth sub areas A2c and A2d) of the second area A2 of the substrate SUB. For example, as illustrated in FIG. 9A, the second plate patterns 122 may be disposed on the third and fourth sub areas A2c and A2d of the substrate SUB in a matrix, but this is just illustrative, but the exemplary embodiment of the present disclosure is not limited thereto.

For example, the first plate patterns 121 and the second plate patterns 122 may be integrally formed on the third and fourth sub areas A2c and A2d of the second area A2.

Specifically, further referring to FIG. 9B, a pattern layer 120_1 may include a plurality of plate patterns 121_1 disposed on the third and fourth sub areas A2c and A2d. The plurality of plate patterns 121_1 may be spaced apart from each other to be disposed on the third and fourth sub areas A2c and A2d of the second area A2 of the substrate SUB. For example, as illustrated in FIG. 9B, each of the plurality of plate patterns 121_1 extends on the third and fourth sub areas A2c and A2d of the substrate SUB along the first direction DR1 and the plurality of plate patterns 121_1 may be disposed to be spaced apart from each other along the second direction DR2.

Further, a plurality of second pixels PX2 including a plurality of sub pixels SPX (for example, sub pixels R, G, and B which have been described with reference to FIG. 4) and the gate driver GD (for example, various transistors, capacitors, and signal lines which configure the gate driver GD) may be disposed on the plurality of plate patterns 121_1. For example, the gate driver GD (for example, various transistors, capacitors, signal lines, and the like which configure the gate driver GD) may be disposed on the plate pattern 121_1 disposed on the third and fourth sub areas A2c and A2d and may be overlapped with the gate area GIA. Further, the second pixel PX2 may be disposed on the plate pattern 121_1 disposed on the third and fourth sub areas A2c and A2d and may not be overlapped with the gate area GIA. Plate pattern 121_1 may be considered to comprise plate patterns 121 and 122 formed integrally.

Referring to FIG. 9A, the first line patterns 123 may be disposed on the second area A2 of the substrate SUB. For example, the first line patterns 123 may be disposed above each of the first to eighth sub areas A2a to A2h of the substrate SUB.

The first line patterns 123 are patterns which are disposed on the second area A2 and connect the first plate patterns 121 which are adjacent to each other and may be referred to as first connection patterns. That is, at least one first line pattern 123 may be disposed between the first plate patterns 121.

In one exemplary embodiment, referring to FIGS. 8 and 9A, each of the first line patterns 123 has a wavy shape. For example, the first line pattern 123 may have a sinusoidal shape. However, this is just illustrative, so that the shape of the first line pattern 123 is not limited thereto. For example, each of the first line patterns 123 may have a zigzag shape. As another example, each of the first line patterns 123 may have various shapes, such as a plurality of rhombic substrates being connected and extending at vertices. As described above, the number and the shape of the first line patterns 123 illustrated in FIGS. 8 and 9A are illustrative and the number and the shape of first line patterns 123 may vary depending on the design.

Further, connection lines 181, 182, and 183 may be disposed above each first line pattern 123. A first line pattern 123 (for example LP of fig. 10) may serve as a substrate to support a connection line (for example SD3(CL) of fig. 10).

The second line patterns 124 may be disposed on the second area A2 of the substrate SUB. For example, the second line patterns 124 may be disposed above the third and fourth sub areas A2c and A2d of the substrate SUB, respectively.

The second line patterns 124 are patterns which are disposed on the second area A2 and connect the second plate patterns 122 which are adjacent to each other and may be referred to as second connection patterns. That is, at least one second line pattern 124 may be disposed between the second plate patterns 122.

In one exemplary embodiment, referring to FIG. 9A, each of the second line patterns 124 may have a wavy shape. For example, the second line pattern 124 may have a sinusoidal shape. However, this is just illustrative, so that the shape of the second line pattern 124 is not limited thereto. For example, each of the second line patterns 124 may have a zigzag shape. As another example, each of the second line patterns 124 may have various shapes, such as a plurality of rhombic substrates being connected and extending at vertices. As described above, the number and the shape of the second line patterns 124 illustrated in FIG. 9A are illustrative and the number and the shape of the second line patterns 124 may vary depending on the design.

Further, fourth connection lines 184 may be disposed above each second line pattern 124. A second line pattern 124 may serve as a substrate to support a connection line.

In one exemplary embodiment, the first plate patterns 121, the second plate patterns 122, the first line patterns 123, and the second line patterns 124 are rigid patterns, respectively. For example, each of the first plate patterns 121, the second plate patterns 122, the first line patterns 123, and the second line patterns 124 may be more rigid than the substrate SUB. Accordingly, moduli of elasticity of the first plate patterns 121, the second plate patterns 122, the first line patterns 123, and the second line patterns 124 may be higher than a modulus of elasticity of the substrate SUB. The modulus of elasticity is a parameter representing a rate of deformation against the stress applied to the substrate and the higher the modulus of elasticity, the higher the hardness. Therefore, the first plate patterns 121, the second plate patterns 122, the first line patterns 123, and the second line patterns 124 may be referred to as first to fourth rigid patterns, respectively. For example, each of moduli of elasticity of the first plate patterns 121, the second plate patterns 122, the first line patterns 123, and the second line patterns 124 may be 1000 times higher than the modulus of elasticity of the substrate SUB, but this is illustrative, and the exemplary embodiment of the present disclosure is not limited thereto.

In the exemplary embodiment, each of the first plate patterns 121, the second plate patterns 122, the first line patterns 123, and the second line patterns 124 may include a plastic material having a lower flexibility than the substrate SUB. For example, each of the first plate patterns 121, the second plate patterns 122, the first line patterns 123, and the second line patterns 124 may include at least one material of polyimide (PI), polyacrylate, and polyacetate.

According to the exemplary embodiment, the first plate patterns 121, the second plate patterns 122, the first line patterns 123, and the second line patterns 124 may be formed of the same material but are not limited thereto and may be formed of different materials. When the first plate patterns 121, the second plate patterns 122, the first line patterns 123, and the second line patterns 124 are formed of the same material, the first plate patterns 121, the second plate patterns 122, the first line patterns 123, and the second line patterns 124 may be integrally formed.

In one exemplary embodiment, as illustrated in FIG. 8, in the first, second, fifth, sixth, seventh, and eighth areas A2a, A2b, A2e, A2f, A2g, and A2h, a first connection line 181 which extends along the first direction DR1 and a second connection line 182 which extends along the second direction DR2 may be disposed on the first line patterns 123.

Here, the first connection line 181 and the second connection line 182 may be connection lines which connect the second pixels PX2 disposed above the first plate patterns 121 which are spaced apart from each other on the first, second, fifth, sixth, seventh, and eighth areas A2a, A2b, A2e, A2f, A2g, and A2h.

Further, in one exemplary embodiment, as illustrated in FIG. 9A, in the third and fourth sub areas A2c and A2d, the third connection line 183 which extends along the second direction DR2 and the fourth connection line 184 which extends along the second direction DR2 may be disposed on the first line patterns 123.

Here, the third connection line 183 may be a connection line which connects the second pixels PX2 disposed above the first plate patterns 121 which are spaced apart from each other on the third and fourth sub areas A2c and A2d.

Further, the fourth connection line 184 may be a connection line which connects the gate drivers GD disposed above the second plate patterns 122 which are spaced apart from each other on the third and fourth sub areas A2c and A2d.

The sub pixels SPX may be connected to the plurality of connection lines 181, 182 and 183.

For example, the sub pixels SPX included in the second pixel PX2 disposed on the first, second, fifth, sixth, seventh, and eighth areas A2a, A2b, A2e, A2f, A2g, and A2h of the second area A2 may be electrically connected to the first connection line 181 which extends along the second direction DR2 and the second connection line 182 which extends along the first direction DR1.

As another example, the sub pixels SPX included in the second pixel PX2 disposed on the third and fourth sub areas A2c and A2d of the second area A2 may be electrically connected to the third connection line 183 which extends along the second direction DR2.

In one exemplary embodiment, connection lines 181, 182, and 183 connected to the sub pixels SPX may include various wiring lines, such as a gate line (for example, a scan signal line or an emission control line), a data line, a high potential voltage line, a low potential voltage line, and an initialization voltage line.

As described above, the gate driver GD is disposed above the second plate pattern 122 on the gate area GIA to supply the gate signal to the pixels PX (for example, the first pixels PX1 and the second pixels PX2). Further, as illustrated in FIGS. 5 and 9A, the gate area GIA may be disposed so as to overlap a part (for example, the third and fourth sub areas A2c and A2d) of the first area A1 and the second area A2.

The gate driver GD includes a plurality of stages formed above the plurality of second plate patterns 122, respectively, and each stage included in the gate driver GD may be electrically connected to each other by means of the plurality of gate connection lines. Accordingly, a gate signal output from any one of stages may be transmitted to the other stage. Each stage may sequentially supply a gate signal to the plurality of pixels PX (for example, the first pixel PX1 or the second pixel PX2) connected to each stage.

Further, the gate driver GD may be connected to the fourth connection lines 184.

For example, the gate driver GD (for example, a stage included in the gate driver GD) disposed on the third and fourth sub areas A2c and A2d of the second area A2 may be electrically connected to the fourth connection line 184 which extends along the second direction DR2.

FIG. 10 is a cross-sectional view illustrating an example taken along the line III-III' of FIG. 5.

In order to avoid redundant description, contents which do not overlap the description with reference to FIGS. 1 to 9B will be mainly described. A part which is not specifically described follows the above-described exemplary embodiment and the same reference numeral denotes the same component, and the like reference numeral denotes the like component.

In FIG. 10, a cross-sectional structure of the display device 1000 in a second area A2 (for example, the third sub area A2c), a connection area CA, and a driving area DA is illustrated. Here, the driving area DA may correspond to an area in which the data driver DD, etc. is disposed and the connection area CA may refer to an area between the display panel DP and the data driver DD.

Referring to FIGS. 5 to 10, a pattern layer 120 and various insulating layers (for example, first and second buffer layers BUF1 and BUF2, first and second gate insulating layers GI1 and GI2, first to fourth insulating layers ILD1 to ILD4, first to third planarization layers PNL1 to PNL3) may be disposed on the substrate SUB.

Further, the transistors TR1 and TR2, the light emitting diode LD, the encapsulation layer (for example, first to third inorganic encapsulation layers PAS1, PAS2, and PAS3 and first and second organic encapsulation layers PCL1 and PCL2) above the light emitting diode LD may be disposed on the second area A2 of the substrate SUB or the pattern layer 120. For example, the transistors TR1 and TR2, the light emitting diode LD, the encapsulation layer (for example, first to third inorganic encapsulation layers PAS1, PAS2, and PAS3 and the first and second organic encapsulation layers PCL1 and PCL2) above the light emitting diode LD may be disposed on the plate pattern PP of the pattern layer 120. The plate pattern PP illustrated in FIG. 10 may be plate patterns 121, 121_1, and 122 which have been described with reference to FIGS. 8, 9A, and 9B.

Further, the data driver DD is disposed on the driving area DA of the substrate SUB or the pattern layer 120 and the connection signal line CL which connects the display panel DP and the data driver DD may be disposed on the connection area CA of the substrate SUB or the pattern layer 120. For example, the data driver DD may be disposed on the plate pattern PP disposed in the driving area DA of the pattern layer 120 and the connection signal line CL which connects the display panel DP and the data driver DD may be disposed on the line pattern LP disposed on the connection area CA of the pattern layer 120. The line pattern LP illustrated in FIG. 10 may be line patterns 123 and 124 which have been described with reference to FIGS. 8, 9A, and 9B.

In one exemplary embodiment, at least a part of the seventh conductive layer SD3 disposed above the second planarization layer PNL2 may extend to be disposed to the connection area CA and the driving area DA from the second area A2 (for example, the third sub area A2c). At least a part (for example, the connection signal line CL) of the seventh conductive layer SD3 may be disposed on the pattern layer 120 (for example, the line pattern LP) to be in direct contact with the pattern layer 120 (for example, the line pattern LP) on the connection area CA.

As described above, in the display device according to the exemplary embodiments of the present disclosure, a gate area in which various components configuring a gate driver are disposed may be disposed so as to overlap at least a part of an active area (a first area or a second area) in which various components configuring a pixel are disposed. That is, the gate driver is disposed and formed on a gate area in a gate in array (GIA) manner so that a bezel area of the display device may be minimized.

Further, a display device according to exemplary embodiments of the present disclosure includes a first area which is a center area, and a second area which is an outer peripheral area enclosing the first area. Second pixels disposed in the second area may be disposed with a lower pixel density than that of first pixels disposed in the first area. Therefore, in the second area which is an outer peripheral area, the display device can be modified so that the second area which is an outer peripheral area may be configured to have a curved shape.

The exemplary embodiments of the present disclosure can also be described as follows:

According to an aspect of the present disclosure, a display device includes a display panel which includes a plurality of pixels and includes a substrate divided into a first area disposed at the center and a second area which encloses the first area; a data driver configured to supply a data signal to the pixels through data lines; and a gate driver including a plurality of stages configured to supply a gate signal to the pixels through gate lines. Each of the plurality of stages included in the gate driver is disposed in a gate area which at least partially overlaps the first area and the second area, the plurality of pixels includes a plurality of first pixels disposed on the first area and a plurality of second pixels disposed on the second area, and the first pixels may be disposed in the first area at a first density and the second pixels may be disposed in the second area at a second pixel density which is lower than the first pixel density.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. All the technical concepts in the equivalent scope of the present disclosure should be construed as falling within the scope of the present disclosure.

Also disclosed herein are the following numbered clauses:
1. A display device, comprising:
   a display panel which includes a plurality of pixels and includes a substrate divided into a first area disposed at a center of the display device and a second area which surrounds the first area;
   a data driver configured to supply a data signal to the pixels through data lines; and
   a gate driver including a plurality of stages configured to supply a gate signal to the pixels through gate lines,
   wherein each of the plurality of stages included in the gate driver is disposed in a gate area which at least partially overlaps the first area and the second area, the plurality of pixels includes a plurality of first pixels disposed on the first area and a plurality of second pixels disposed on the second area, wherein the first pixels are disposed in the first area at a first pixel density and the second pixels are disposed in the second area at a second pixel density which is lower than the first pixel density.
2. The display device of clause 1 wherein a plurality of first plate patterns are disposed in the second area; and wherein the second pixels are disposed on at least some of the first plate patterns.
3. The display device of any preceding clause wherein the gate area extends along a first direction of the display device and a plurality of gate areas are spaced apart from each other along a second direction of the display device perpendicular to the first direction; and optionally wherein the first direction is from top to bottom of the display device.
4. The display device of any preceding clause wherein the second area comprises a plurality of sub areas, wherein a respective sub area is disposed adjacent to each side of the first area.
5. The display device of clause 4 wherein the first plate patterns are disposed in each sub area.
6. The display device of any of clauses 2 to 5 wherein second plate patterns are disposed in sub areas opposite upper and lower sides of the first area.
7. The display device of clause 6 wherein the gate driver is disposed on the second plate patterns; and optionally wherein the second plate patterns are disposed in between respective first plate patterns.
8. The display device of any of clauses 2 to 7 wherein the first and the second plate patterns are disposed integrally in the sub areas opposite upper and lower sides of the first area and extend in the second direction parallel to the upper and lower sides of the first area and are spaced apart from each other in the first direction perpendicular to the second direction.
9. The display device of any of clauses 2 to 8 wherein at least one first line pattern is disposed in the second area to connect each adjacent first plate pattern.
10. The display device of any of clauses 6 to 9 wherein at least one second line pattern is disposed in the second area to connect each adjacent second plate pattern.
11. The display device of clause 9 or 10 wherein at least one first line pattern and/or at least one second line pattern serve as a substrate to support a connection line.
12. The display device of clause 10 or 11 wherein the first plate patterns, the second plate patterns, the first line patterns, and the second line patterns are formed of the same material; and optionally, wherein the material is more rigid than the substrate.
13. The display device of any of clauses 2 to 12 wherein the second pixels include sub pixels.
14. The display device of any preceding clause wherein the substrate is flexible, and optionally the substrate is formed of plastic.
15. The display device of any preceding clause wherein the substrate comprises double polyimide layers, and optionally an inorganic film is formed between the two polyimide layers.

A1. A display device, comprising:
a display panel which includes a plurality of pixels and includes a substrate divided into a first area disposed at a center and a second area which encloses the first area;
a data driver configured to supply a data signal to the pixels through data lines; and
a gate driver including a plurality of stages configured to supply a gate signal to the pixels through gate lines,
wherein each of the plurality of stages included in the gate driver is disposed in a gate area which at least partially overlaps the first area and the second area, the plurality of pixels includes a plurality of first pixels disposed on the first area and a plurality of second pixels disposed on the second area, and the first pixels are disposed in the first area at a first density and the second pixels are disposed in the second area at a second pixel density which is lower than the first pixel density.

A2. The display device according to clause A1,
wherein the second area includes:
a first sub area adjacent to one side of the first area along a first direction;
a second sub area adjacent to the other side of the first area along the first direction;
a third sub area adjacent to one side of the first area along a second direction which is different from the first direction;
a fourth sub area adjacent to the other side of the first area along the second direction;
a fifth sub area between the first sub area and the third sub area;
a sixth sub area between the first sub area and the fourth sub area;
a seventh sub area between the second sub area and the third sub area; and
an eighth sub area between the second sub area and the fourth sub area.

A3. The display device according to clause A2,
further comprising:
a pattern layer which is disposed on the second area of the substrate and includes a plurality of first plate patterns, a plurality of second plate patterns, a plurality of first line patterns, and a plurality of second line patterns.

A4. The display device according to clause A3,
wherein the plurality of first plate patterns is disposed to be spaced apart from each other and the plurality of first line patterns connects the first plate patterns which are adjacent to each other, in the first, second, fifth, sixth, seventh, and eighth sub areas.

A5. The display device according to clause A4,
further comprising:
a plurality of connection lines disposed on the plurality of first line patterns,
wherein each of the plurality of second pixels is disposed above each of the plurality of first plate patterns and each of the plurality of connection lines is disposed above each of the plurality of first line patterns to connect the second pixels, in the first, second, fifth, sixth, seventh, and eighth sub areas.

A6. The display device according to clause A3,
wherein the plurality of first plate patterns is disposed to be spaced apart from each other and the plurality of first line patterns connects the first plate patterns which are adjacent to each other along the second direction, in the third and fourth sub areas.

A7. The display device according to clause A6,
further comprising:
a plurality of connection lines disposed on the plurality of first line patterns,
wherein each of the plurality of second pixels is disposed above each of the plurality of first plate patterns and each of the plurality of connection lines is disposed above each of the plurality of first line patterns to connect the second pixels, in the third and fourth sub areas.

A8. The display device according to clause A3, wherein the plurality of second plate patterns is disposed to be spaced apart from each other and the plurality of second line patterns connects the second plate patterns which are adjacent to each other along the second direction, in the third and fourth sub areas.

A9. The display device according to clause A8,
further comprising:
a plurality of connection lines disposed on the plurality of second line patterns,
wherein each of the plurality of stages included in the gate driver is disposed above each of the plurality of second plate patterns and each of the plurality of connection lines is disposed above each of the plurality of second line patterns to connect the stages, in the third and fourth sub areas.

A10. The display device according to any of clauses A2 to A9,
wherein the gate area overlaps the first area, the third sub area, and the fourth sub area.

A11. The display device according to any of clauses A3 to A10,
wherein each of the plurality of second plate patterns and the plurality of second line patterns is disposed to overlap the gate area.

A12. The display device according to any preceding clause, further comprising:
a power line which is disposed on the gate area and supplies a low potential power voltage to the pixels.

A13. The display device according to any preceding clause,
wherein the display panel includes:
a first buffer layer disposed on the substrate;
a first semiconductor layer which is disposed on the first buffer layer and includes a first semiconductor pattern of a first transistor;
a first gate insulating layer disposed on the first semiconductor layer;
a first conductive layer which is disposed on the first gate insulating layer and includes a first gate electrode of the first transistor;
a first insulating layer disposed on the first conductive layer;
a second conductive layer disposed on the first insulating layer;
a second insulating layer disposed on the second conductive layer;
a third conductive layer which is disposed on the second insulating layer and includes a first source electrode and a first drain electrode of the first transistor; and
a third insulating layer disposed on the third conductive layer.

A14. The display device according to clause A13,
wherein the display panel further includes:
a second buffer layer disposed on the third insulating layer;
a second semiconductor layer which is disposed on the second buffer layer and includes a second semiconductor pattern of a second transistor;
a second gate insulating layer disposed on the second semiconductor layer;
a fourth conductive layer which is disposed on the second gate insulating layer and includes a second gate electrode of the second transistor;
a fourth insulating layer disposed on the fourth conductive layer; and
a fifth conductive layer which is disposed on the fourth insulating layer and includes a second source electrode and a second drain electrode of the second transistor.

A15. The display device according to clause A14,
wherein the fifth conductive layer further includes a clock line.

A16. The display device according to clause A14,
wherein the display panel further includes:
a first planarization layer disposed on the fifth conductive layer;
a sixth conductive layer disposed on the first planarization layer;
a second planarization layer disposed on the sixth conductive layer; and
a seventh conductive layer disposed on the second planarization layer.

A17. The display device according to clause A16,
wherein the substrate further includes a driving area in which the data driver is disposed and a connection area between the second area and the driving area, and the seventh conductive layer extends to be disposed from the second area to the connection area and the driving area.

A18. The display device according to clause A17,
wherein the seventh conductive layer is in direct contact with the substrate on the connection area.

A19. The display device according to clause A16,
wherein the display panel further includes:
a light emitting diode disposed on the seventh conductive layer; and
an encapsulation layer disposed above the light emitting diode, and
the encapsulation layer includes:
   a first inorganic encapsulation layer disposed above the light emitting diode;
   a first organic encapsulation layer disposed on the first inorganic encapsulation layer;
   a second inorganic encapsulation layer disposed on the first organic encapsulation layer;
   a second organic encapsulation layer disposed on the second inorganic encapsulation layer; and
   a third inorganic encapsulation layer disposed on the second organic encapsulation layer.

A20. The display device according to any preceding clause,
wherein the display panel includes a light emitting diode, a clock line configured to supply a clock signal to the gate driver, and a shielding pattern disposed between the light emitting diode and the clock line.

**The description comprises the following items:**
1. A display device, comprising:
   a display panel which includes a plurality of pixels and includes a substrate divided into a first area disposed at a center of the display device and a second area which surrounds the first area;
   a data driver configured to supply a data signal to the pixels through data lines; and
   a gate driver including a plurality of stages configured to supply a gate signal to the pixels through gate lines,
   wherein each of the plurality of stages included in the gate driver is disposed in a gate area which at least partially overlaps the first area and the second area, the plurality of pixels includes a plurality of first pixels disposed on the first area and a plurality of second pixels disposed on the second area, wherein the first pixels are disposed in the first area at a first pixel density and the second pixels are disposed in the second area at a second pixel density which is lower than the first pixel density.
2. The display device of item 1 wherein a plurality of first plate patterns are disposed in the second area; and wherein the second pixels are disposed on at least some of the first plate patterns.
3. The display device of any preceding item wherein the gate area extends along a first direction of the display device and a plurality of gate areas are spaced apart from each other along a second direction of the display device perpendicular to the first direction; and optionally wherein the first direction is from top to bottom of the display device.
4. The display device of any preceding item wherein the second area comprises a plurality of sub areas, wherein a respective sub area is disposed adjacent to each side of the first area.
5. The display device of item 4 wherein the first plate patterns are disposed in each sub area.
6. The display device of any of items 2 to 5 wherein second plate patterns are disposed in sub areas opposite upper and lower sides of the first area.
7. The display device of item 6 wherein the gate driver is disposed on the second plate patterns; and optionally wherein the second plate patterns are disposed in between respective first plate patterns.
8. The display device of any of items 2 to 7 wherein the first and the second plate patterns are disposed integrally in the sub areas opposite upper and lower sides of the first area and extend in the second direction parallel to the upper and lower sides of the first area and are spaced apart from each other in the first direction perpendicular to the second direction.
9. The display device of any of items 2 to 8 wherein at least one first line pattern is disposed in the second area to connect each adjacent first plate pattern.
10. The display device of any of items 6 to 9 wherein at least one second line pattern is disposed in the second area to connect each adjacent second plate pattern.
11. The display device of item 9 or 10 wherein at least one first line pattern and/or at least one second line pattern serve as a substrate to support a connection line.
12. The display device of any preceding item wherein a first conductive layer and a second conductive layer are positioned on layers in-between the first and/or second pixels and a first and/or second transistor; and further wherein at least a part of the first conductive layer forms a connection line comprising a wavy shape.
13. The display device of item 12 wherein the at least a part of the first conductive layer forming the connection line is disposed directly on the line pattern serving as a substrate.
14. The display device of item 12 or 13 wherein at least a part of the first conductive layer is arranged to form a shielding pattern.
15. The display device of item 14 wherein the shielding pattern is arranged between at least a part of a third conductive layer serving as a clock line and an anode of a pixel; and optionally wherein the shielding pattern has a width larger than the anode of the pixel and the pixel.

## Claims

1. A display device, comprising:
a substrate (SUB) including a first area (A1) in which a plurality of first pixels (PX1) are disposed; a second area (A2) surrounding a first area, in which a plurality of second pixels (PX2) are disposed; and a driving area (DA) disposed on one side of the second area;
a data driver (DD) on the driving area;
a gate driver (GD) including a plurality of stages on the first area and the second area;
a plurality of first plate patterns (121) on the second area;
a plurality of second plate patterns (122) on the second area;
a plurality of first line patterns (123) on the second area and connecting the plurality of first plate patterns; and
a plurality of second line patterns (124) on the second area and connecting the plurality of second plate patterns,
wherein the plurality of second pixels are disposed on the plurality of first plate patterns.

2. The display device of claim 1, wherein moduli of elasticity of the plurality of first plate patterns, the plurality of second plate patterns, the plurality of first line patterns and the plurality of second line patterns are higher than a modulus of elasticity of the substrate.

3. The display device of claim 1, wherein the plurality of first line patterns and the plurality of second line patterns have a wavy shape.

4. The display device of claim 1, further comprising:
a plurality of connection lines (181, 182, 183) disposed on the plurality of first line patterns,
wherein the plurality of connection lines connect the plurality of second pixels.

5. The display device of claim 1, wherein the plurality of stages is disposed on the plurality of second plate patterns.

6. The display device of claim 5, further comprising:
a plurality of connection lines (184) disposed on the plurality of second line patterns,
wherein the plurality of connection lines connect the plurality of stages.

7. The display device of claim 1, wherein each of the plurality of second plate patterns is disposed between the plurality of first plate patterns.

8. The display device of claim 1, wherein the plurality of first plate patterns and the plurality of second plate patterns are spaced apart from each other.

9. The display device of claim 1, wherein in the first direction (DR1), the plurality of first plate patterns and the plurality of second plate patterns are integrally formed, and
wherein in the second direction (DR2) different from the first direction, the plurality of first plate patterns and the plurality of second plate patterns are spaced apart from each other.

10. The display device of claim 1, wherein the second area includes:
a first sub area (A2a) adjacent to one side of the first area along a first direction (DR1);
a second sub area (A2b) adjacent to the other side of the first area along the first direction;
a third sub area (A2c) adjacent to one side of the first area along a second direction (DR2) which is different from the first direction; and
a fourth sub area (A2d) adjacent to the other side of the first area along the second direction,
wherein the third sub area is disposed adjacent to the driving area, and
wherein the gate driver is disposed on the first area, the third sub area and the fourth sub area.

11. The display device of claim 10, wherein the plurality of second plate patterns and the plurality of second line patterns is disposed on the third sub area and the fourth sub area of the second area.

12. The display device of claim 1, further comprising:
a light emitting diode (LD) in each of the plurality of first pixels;
a clock line (CLK) disposed under the light emitting diode and configured to supply a clock signal to the gate driver; and
a shielding pattern (SM) between the light emitting diode and the clock line,
wherein the shielding pattern overlaps an anode (AND) of the light emitting diode and the clock line.

13. The display device of claim 12, wherein the shielding pattern have a width larger than a width of the anode.

14. The display device of claim 1, the first pixels are disposed in the first area at a first density and the second pixels are disposed in the second area at a second pixel density which is lower than the first pixel density.

15. The display device of claim 1, wherein the second area has flexibility and stretchability.
